# DEMANDE DE BREVET EUROPEEN

(11) **EP 0 984 479 A1**
(43) Date de publication de la demande: **08.03.2000**
(21) Numéro de dépôt: 99402174.9
(22) Date de dépôt: 02.09.1999
(51) Int. Cl.: H01H 85/34

(54) **Procédé et insatallation de vérification du positionnement des fusibles dans une boîte à fusibles**

(30) Priorité: 04.09.1998 FR 9811098
(71) Demandeur: Société Anonyme SYLEA, 78190 Montigny le Bretonneux (FR)
(72) Inventeur: Belly, Christian, 31700 Blagnac (FR)
(74) Mandataire: Faber, Jean-Paul

(57) **Abrégé**

Installation de vérification du positionnement des fusibles dans une boîte à fusibles, dans laquelle les fusibles comportent des codes barres (9) correspondant à leur intensité, ladite installation comprenant un testeur pourvu d'un lecteur (10) de codes barres (9) caractérisée en ce que le testeur de codes barres (9) est programmé suivant un ordre séquentiel de placement des fusibles dans la boîte à fusibles, cette dernière comportant des moyens de guidage (12) du lecteur de codes barres, afin de comparer l'ordre de placement des fusibles par rapport à celui programmé dans le testeur, celui-ci étant agencé de manière à émettre un signal dans le cas où l'ordre de placement est différent de celui programmé.

## Description

La présente invention se rapporte à un procédé et à une installation de vérification du positionnement des fusibles dans une boîte à fusibles.

De plus en plus, notamment dans l'industrie automobile, on réalise un ensemble comprenant le câblage électrique avec les différentes connexions et la boîte à fusibles, cet ensemble étant posé au cours de la réalisation du véhicule.

Comme les véhicules comportent un nombre d'équipements électriques qui va croissant, les boîtes à fusibles sont de plus en plus importantes et le nombre des fusibles, avec des intensités différentes, est également important. Pour faciliter la mise en place des fusibles en fonction des intensités qu'ils peuvent supporter, on a prévu des couleurs différentes afin que les ouvriers chargés de réaliser les câblages et de mettre en place lesdits fusibles évitent de faire des erreurs.

On a pu constater que, malgré le soin apporté pour la réalisation d'un câblage, il était toujours possible qu'un fusible d'une intensité donnée soit inversé avec un fusible d'une autre intensité, avec les risques qu'une telle erreur peut entraîner.

L'un des buts de la présente invention est d'éliminer de tels risques.

L'installation de vérification du positionnement des fusibles dans une boîte à fusibles, objet de l'invention, est du type dans lequel les fusibles comportent des codes barres correspondant à leur intensité, ladite installation comprenant un testeur pourvu d'un lecteur de codes barres et est caractérisée en ce que le testeur est programmé suivant un ordre séquentiel de placement des fusibles dans la boîte à fusibles, cette dernière comportant des moyens de guidage du lecteur de codes barres sur la boîte à fusibles de manière à comparer l'ordre de placement des fusibles par rapport à celui programmé dans le testeur, celui-ci étant agencé de manière à émettre un signal dans le cas où l'ordre de placement est différent de celui programmé.

Grâce à cette disposition, on peut, très rapidement, lorsqu'un câblage est terminé, vérifier que les fusibles sont convenablement positionnés.

Suivant une caractéristique constructive, les moyens de guidage comprennent une plaquette avec, à ses extrémités, des rebords destinés à coopérer avec les côtés correspondants de la boîte à fusibles, ladite plaquette présentant deux bords longitudinaux, séparés d'une distance correspondant à la largeur du lecteur de codes barres, et une large ouverture destinée à s'ouvrir en regard d'une rangée de fusibles.

De préférence, la boîte à fusibles comporte des butées pour caler la plaquette au droit des rangées de fusibles.

L'invention va maintenant être décrite avec plus de détails en se référant à un mode de réalisation particulier, donné à titre d'exemple seulement, et représenté aux dessins annexés dans lesquels

Figure 1 montre en perspective un fusible destiné à être utilisé avec l'installation selon l'invention.

Figure 2 montre schématiquement un testeur.

Figure 3 montre en perspective une boîte à fusibles avec les moyens de guidage du lecteur de codes barres.

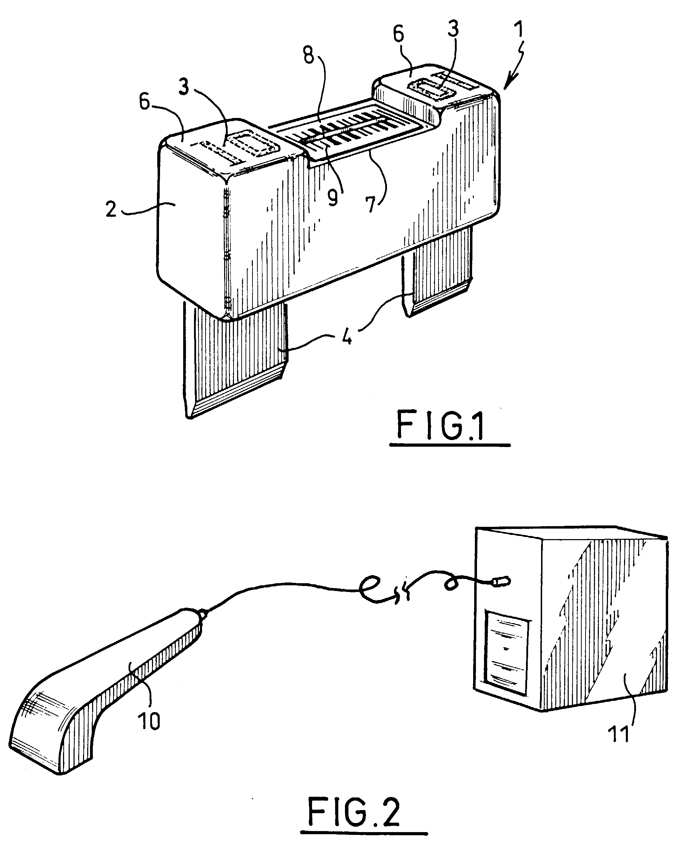

A la figure 1 on a représenté un fusible désigné dans son ensemble par la référence 1 et comprenant un corps isolant 2 en matière plastique colorée.

Dans le corps 2, s'étend un fil fusible dont les extrémités sont solidaires de deux broches 4 destinées à être insérées dans des organes de contact électrique femelles d'une boîte à fusibles 5.

Le corps 2, au droit de chaque broche 4, présente une partie en relief 6 portant une inscription 3 correspondant à l'ampérage du fusible.

Les parties en relief 6 sont reliées par une plage 7 avec une fente centrale 8. Sur la plage 7 sont portés des codes barres 9.

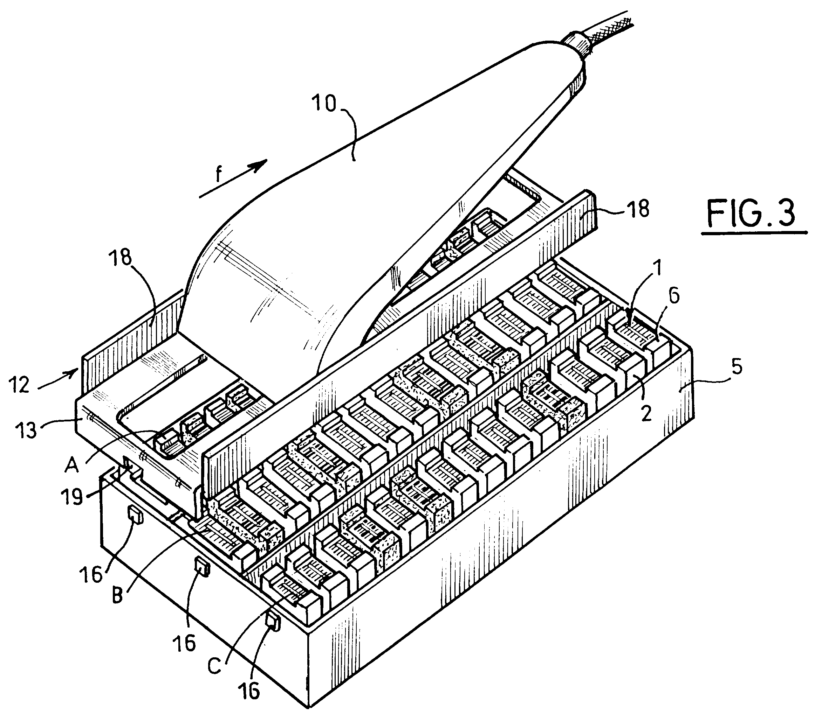

Comme on le voit à la figure 3, les différents fusibles 1 sont disposés par rangées A, B, C dans la boîte à fusibles 5 et, dans chaque rangée, on trouve des fusibles avec différents ampérages.

Normalement, pour que la personne chargée de mettre en place les fusibles 1 dans la boîte 5 ne se trompe pas en fonction des ampérages, les corps 2 ont des couleurs différentes, rouge, jaune, vert, bleu, etc....

On conçoit que, malgré le soin apporté au garnissage des boîtes à fusibles, il est toujours possible d'inverser au moins deux fusibles ayant des ampérages différents.

Pour remédier à cet inconvénient et pour pouvoir vérifier ensuite que tous les fusibles 1 sont bien, dans la boîte 5, disposés suivant l'ordre prévu, sur chaque fusible, on prévoit un code barres 9 correspondant à son ampérage et on utilise un testeur 11 comprenant un lecteur 10 de codes barres.

Sur la boîte à fusibles 5 il est prévu un guide 12 formé d'une plaquette comprenant deux rebords 13 destinés à coopérer avec les petits côtés de ladite boîte à fusibles. Chaque rebord 13 présente une fente 19 et des butées 16 sont prévues sur les petits côtés de la boîte à fusibles 5 et destinées à s'insérer dans les fentes 19 afin de caler le guide dans des positions convenables.

Le guide 12 présente une ouverture 17 et deux bords longitudinaux 18, séparés d'une distance correspondant à la largeur du lecteur 10 de codes barres.

Dans le testeur 11, on a préalablement programmé l'ordre séquentiel des fusibles de manière que les rangées soient vérifiées dans un ordre déterminé soit : rangée A, rangée B et rangée C, chacune dans le sens de la flèche f.

Lorsque le câblage est terminé et que les fusibles ont été mis en place sur la boîte à fusibles 5, on place le guide 12 en regard de la rangée A et on déplace entre les bords 18, dans le sens de la flèche f, le lecteur 10. Si une anomalie est révélée, le testeur 11 émet un signal. On procède de la même façon pour chaque rangée B et C.

Bien entendu, l'invention n'est pas limitée au mode de réalisation qui vient d'être décrit et représenté. On pourra y apporter de nombreuses modifications de détail sans sortir pour cela du cadre de l'invention.

## Revendications

1. Installation de vérification du positionnement des fusibles dans une boîte à fusibles, dans laquelle les fusibles comportent des codes barres (9) correspondant à leur intensité, ladite installation comprenant un testeur (11) pourvu d'un lecteur (10) de codes barres (9) caractérisée en ce que le testeur (11) de codes barres (9) est programmé suivant un ordre séquentiel de placement des fusibles dans la boîte à fusibles, cette dernière comportant des moyens de guidage (12) du lecteur de codes barres, afin de comparer l'ordre de placement des fusibles par rapport à celui programmé dans le testeur, celui-ci étant agencé de manière à émettre un signal dans le cas où l'ordre de placement est différent de celui programmé.

2. Installation de vérification du positionnement des fusibles dans une boîte à fusibles, selon la revendication 1, caractérisée en ce que les moyens de guidage (12) comprennent une plaquette, avec, à ses extrémités, des rebords (13) destinés à coopérer avec les côtés correspondants de la boîte à fusibles (5), ladite plaquette présentant deux bords longitudinaux (18), séparés d'une distance correspondant à la largeur du lecteur (10) de codes barres, et une large ouverture destinée à s'ouvrir en regard d'une rangée de fusibles (1).

3. Installation de vérification du positionnement des fusibles dans une boîte à fusibles, selon la revendication 1, caractérisée en ce que la boîte à fusibles (5) comporte des butées (16) pour caler la plaquette au droit des rangées de fusibles (1).
